# EUROPÄISCHE PATENTSCHRIFT

(11) **EP 2 406 411 B1**
(45) Veröffentlichungstag und Bekanntmachung des Hinweises auf die Patenterteilung: **08.04.2015**
(21) Anmeldenummer: 09796628.7
(22) Anmeldetag: 18.12.2009
(51) Int. Cl.: C23C 16/455, C30B 25/14, C30B 29/40

(54) **MOCVD-REAKTOR MIT ZYLINDRISCHEM GASEINLASSORGAN**
MOCVD REACTOR WITH CYLINDRICAL GAS INLET DEVICE
RÉACTEUR POUR MOCVD DOTE D'UN ORGANE D'ADMISSION DE GAZ

(30) Priorität: 23.12.2008 DE 102008055582
(43) Veröffentlichungstag der Anmeldung: 18.01.2012
(73) Patentinhaber: Aixtron SE, 52134 Herzogenrath (DE)
(72) Erfinder: BRIEN, Daniel, 52064 Aachen (DE); SCHÖN, Oliver, 52134 Herzogenrath (DE)
(74) Vertreter: Grundmann, Dirk
(86) Internationale Anmeldenummer: PCT/EP2009/009133
(87) Internationale Veröffentlichungsnummer: WO 2010/072380

(56) Entgegenhaltungen:
- DE-A1- 10 064 944
- DE-A1-102004 009 130

## Beschreibung

Die Erfindung betrifft eine Vorrichtung zum Abscheiden von Schichten, insbesondere Halbleiterschichten mit einer im Wesentlichen rotationssymmetrisch um ein Zentrum angeordneten Prozesskammer die einen von einem in einer Horizontalebene angeordneten Suszeptor ausgebildeten Boden, eine vertikal oberhalb des Suszeptors angeordnete Prozesskammerdecke, eine im Zentrum zwischen Suszeptor und Prozesskammerdecke sich erstreckendes Gaseinlassorgan mit vertikal übereinander angeordneten Gaseinlasskammern und eine vertikal unterhalb des Suszeptors angeordnete Heizung zum Aufheizen des Suszeptors aufweist, wobei auf dem Suszeptor eine Vielzahl von mit Abstand zum Gaseinlassorgan angeordnete Substrathalter zur Aufnahme von zu beschichtenden Substraten vorgesehen sind, wobei eine oberste der Gaseinlasskammern unmittelbar der Prozesskammerdecke benachbart und mit einer Zuleitung zum Einleiten eines Hydrides zusammen mit einem Trägergas in die Prozesskammer verbunden ist, wobei eine unterste der Gaseinlasskammern unmittelbar dem Suszeptor benachbart ist und mit einer Zuleitung zum Einleiten eines Hydrides zusammen mit einem Trägergas in die Prozesskammer verbunden ist, wobei zumindest eine zwischen der untersten und der obersten Gaseinlasskammer angeordnete mittlere Gaseinlasskammer mit einer Zuleitung zum Einleiten einer metallorganischen Verbindung in die Prozesskammer verbunden ist.

Die Erfindung betrifft darüber hinaus die Verwendung einer derartigen Vorrichtung zum Abscheiden einer Halbleiterschicht auf einem Substrat, wobei durch die Gasaustrittsöffnungen der obersten Gaseinlasskammer und durch die Gasaustrittsöffnungen der untersten Gaseinlasskammer zusammen mit einem Trägergas ein Hydrid, beispielsweise NH₃, PH₃ oder AsH₃ und durch die Gasaustrittsöffnungen der mittleren Gaseinlasskammer eine metallorganische Verbindung, beispielsweise TMGa, TMIn oder TMAl in die durch die Heizung aufgeheizte Prozesskammer eingeleitet werden.

Die DE 10 2004 009 130 A1 beschreibt ein Gaseinlasssystem für einen MOCVD-Reaktor, bei dem die Prozessgase durch drei vertikal übereinander angeordnete Gaseinlasszonen in verschiedenen Höhen in die Prozesskammer eingeleitet werden. Die Prozesskammer erstreckt sich ringförmig um das im Symmetriezentrum der Prozesskammer angeordnete Gaseinlassorgan. Zum Abscheiden einer III-V-Halbleiterschicht auf einem Substrat, werden durch die unterste und durch die oberste Gaseinlasszone jeweils die V-Komponente in Form eines Hydrides eingeleitet. Durch die dazwischen liegende mittlere Gaseinlasszone wird die III-Komponente in Form einer metallorganischen Verbindung in die Prozesskammer eingeleitet. Die drei übereinander angeordneten Gaseinlasszonen bilden zur Prozesskammer hin offene Gaseinlasskammern aus. Lediglich die mittlere Gaseinlasskammer ist von einem Ringkörper aus einem porösen Material verschlossen. Dieser Ringkörper soll als Druckbarriere wirken. Die Substrate sind ringförmig um das im Zentrum der Prozesskammer angeordnete Gaseinlassorgan gruppiert.

Die DE 10 2005 056 320 A1 beschreibt einen CVD-Reaktor mit einem Gaseinlassorgan, welches zwei vertikal übereinander angeordnete Gaseinlasszonen ausbildet. Eine gekühlte untere Stirnseite des Gaseinlassorgans liegt in einer Bodenaussparung des von unten beheizten Suszeptors ein.

Die DE 10153 463 A1 beschreibt ebenfalls einen MOCVD-Reaktor zum Abscheiden von III-V-Halbleiterschichten mit einem im Zentrum einer Prozesskammer angeordneten Gaseinlassorgan. Hier wird die V-Komponente durch eine Stirnseitenöffnung an der Unterseite des Gaseinlassorganes in die Prozesskammer eingeleitet. Die III-Komponente strömt aus einer darüber angeordneten Gaseinlasskammer, die von einem porösen Ring umgeben ist, in die Prozesskammer.

Eine ähnliche Vorrichtung beschreibt die DE 100 64 941 A1. Dort besitzt die zum Zentrum hin weisende Rückseite der Gaseinlasskammer, die von einem porösen Ring umgeben ist, eine Rotationshyperboloid-Form, um dem aus der porösen Wand austretenden Gasstrom ein bestimmtes Strömungsprofil zu verleihen.

Mit der in der eingangs genannten DE 10 2004 009 130 A1 beschriebenen Maßnahme wird eine erste Verbesserung der Effizienz eines MOCVD-Reaktors erreicht. Dort wird vorgeschlagen, die V-Komponente nicht nur unmittelbar oberhalb des Suszeptors in die Prozesskammer einzuleiten, sondern auch unmittelbar unterhalb der Prozesskammerdecke. Während der Suszeptor von unten her üblicherweise mit einer Widerstandsheizung oder einer IR-Heizung aktiv beheizt wird, um auf der Oberfläche des Suszeptors die erforderliche Prozesstemperatur zu erreichen, wird die Prozesskammerdecke in der Regel nicht aktiv beheizt, sondern meistens aktiv gekühlt. Infolge dessen bildet sich innerhalb der gasdurchströmten Prozesskammer ein vertikaler Temperaturgradient aus.

Die üblicherweise verwendeten Ausgangsstoffe, also PH₃, AsH₃ und NH₃ bzw. TMGa, TMIn oder TMAl zerlegen sich bei unterschiedlichen Temperaturen in der Gasphase. Die Zerlegungstemperatur der metallorganischen Komponenten liegt dabei deutlich niedriger, als die Zerlegungstemperatur der Hydride. Während erstere sich schon bei etwa 170°C zerlegen, liegt die Zerlegungstemperatur von NH₃ weit oberhalb von 1500°C. Die Prozesstemperaturen auf der Oberfläche des Suszeptors, auf welcher die Substrate aufliegen, liegen aber lediglich im Bereich von 500°C bis 1200°C. Das Kristallwachstum wird daher im Wesentlichen von dem Massenangebot der III-Komponente bestimmt. Bei den im Stand der Technik üblichen Totaldrücken von 200 mbar liegt die Wachstumsrate im Bereich zwischen 2 bis 3 µm pro Stunde.

Mit der eingangs beschriebenen Vorrichtung werden vertikale Schichtstrukturen für die Fertigung von hell leuchtenden Leuchtdioden abgeschieden. Wesentlich für die Effizienz, also die Energieausbeute von Leuchtdioden ist die kristalline Güte der Oberfläche, auf welche die p-n-Schichtstrukturen der Leuchtdioden abgeschieden werden. Ein wesentliches Material dieser Schichtstrukturen ist GaN. Da aus wirtschaftlichen Gründen ein Substratmaterial verwendet wird, welches eine andere Kristallgitterkonstante aufweist als GaN, nämlich in der Regel Al₂O₃, muss auf das Substrat eine Pufferschicht abgeschieden werden, um auf letzterer gitterangepasst die eigentlichen aktiven Schichten abscheiden zu können. Das Abscheiden einer derartigen Pufferschicht erfordert zunächst das Abscheiden einer GaN-Nukleationsschicht unmittelbar auf das Saphir-Substrat. Dies erfolgt bei relativ niedrigen Wachstumstemperaturen (zwischen 500°C und 600°C). Auf diese, relativ dünne Nukleationsschicht wird dann eine typischerweise 5 µm dicke Pufferschicht derart abgeschieden, dass ihre Oberfläche, auf welche die aktiven Schichten abgeschieden werden sollen, optimale kristalline Eigenschaften besitzt. Die Güte der Oberfläche der Pufferschicht hängt zum einen vom V-/III-Verhältnis der Ausgangsstoffe in der Gasphase und vom Totaldruck in der Gasphase ab. Beide Werte müssen möglichst groß sein. Mit der Erhöhung des Totaldrucks steigt auch die Zerlegungsrate des Hydrids in der Gasphase. Angestrebt ist somit ein Totaldruck im Bereich des Atmosphärendrucks und eine möglichst hohe Konzentration des Hydrides, also NH₃, in der Gasphase.

Gleichzeitig ist es aus Effizienzgründen wünschenswert, die Wachstumsrate zu steigern. Die Prozesszeit zum Abscheiden der Pufferschicht in MOCVD-Reaktoren, wie sie vom eingangs genannten Stand der Technik beschrieben wird, liegt typischerweise bei zwei Stunden. Eine Erhöhung des TMGa-Flusses zur Steigerung der Wachstumsrate ist zwar möglich, bringt aber nicht den gewünschten Erfolg. Es wurde nämlich beobachtet, dass nur bei relativ niedrigen TMGa-Konzentrationen in der Gasphase die Wachstumsrate linear mit der TMGa-Konzentration ansteigt. Ab einer gewissen TMGa-Konzentration treten Sättigungseffekte auf. Diese Sättigungseffekte führen zu einer dramatisch sinkenden Materialeffizienz des Prozesses. Trotz vermehrter Zugabe von Ausgangsstoffen erhöht sich die Materialabscheidung nur geringfügig.

Die Steigerung der TMGa-Konzentration in der Gasphase führte aber nicht nur zu einer Verminderung der Materialeffizienz, sondern auch zu einer Steigerung homogener Gasphasenreaktionen zwischen den einzelnen Ausgangsstoffen in der Gasphase.

Ferner wurde beobachtet, dass eine Steigerung des Totaldrucks innerhalb der Prozesskammer über die typischerweise verwendeten 200 mbar hinaus zum Zwecke des Erzielens einer höheren Zerlegungsrate des Hydrides ebenfalls eine Steigerung homogener Gasphasenreaktionen zwischen den Ausgangsstoffen zur Folge hat. Unter den hier relevanten homogenen Gasphasenreaktionen werden Nukleationen innerhalb der Gasphase verstanden in der Art einer Aduktbildung zwischen der metallorganischen Komponente und dem Hydrid. Die Anzahl der Nukleationen hängt zum einen von der Prozesstemperatur und zum anderen von der Verweilzeit der Ausgangsstoffe in einem kritischen Temperaturbereich von 500°C bis 700°C ab. Die Anzahl der Nukleationen hängt darüber hinaus von den Keimbildungsvoraussetzungen innerhalb der Prozesskammer und insbesondere innerhalb der Gasphase ab. Es wurde beobachtet, dass die Keimbildung überproportional vom Gradienten der Geschwindigkeit und der Temperatur in der Gasphase abhängt.

Bei Gaseinlasssystemen, wie sie vom oben genannten Stand der Technik beschrieben werden, können sich hohe Temperaturgradienten und zufolge von Abrisskanten auch hohe Geschwindigkeitsgradienten ausbilden. Diese liegen unglücklicherweise in einem Bereich, in dem die Gastemperatur im kritischen Temperaturbereich zwischen 500°C und 700°C liegt. Die Ausgangsstoffe müssen nämlich zur Vermeidung von Vorreaktionen innerhalb des Gaseinlassorganes möglichst gekühlt bis in den Einlassbereich der Prozesskammer eingeleitet werden.

Die Erfindung geht von der durch Experimente und theoretischen Überlegungen gewonnenen Erkenntnis aus, dass mit der bisherigen Reaktorgeometrie und insbesondere mit der bisherigen Gestaltung des Gaseinlassorganes keine Steigerung der Wachstumsrate durch weiteres Erhöhen der TMGa-Konzentration in der Gasphase und auch keine Verbesserung der Kristallqualität durch Erhöhung des Totaldrucks möglich ist. Der Erfindung liegt die Aufgabe zugrunde, Maßnahmen anzugeben, mit denen eine weitere Steigerung der Wachstumsrate durch Erhöhung der Zufuhr der III-Komponente und eine Verbesserung der Kristallqualität durch Erhöhung des Totaldrucks möglich ist, ohne dass die beim Stand der Technik beobachteten schädlichen Nukleationen eintreten.

Gelöst wird die Aufgabe durch die in den Ansprüchen angegebene Erfindung.

Im Wege einer Vielzahl sowohl experimentell als auch theoretisch vollzogenen Optimierungsversuchen hat sich herausgestellt, dass eine Modifizierung des Gaseinlassorganes die oben genannte Aufgabe löst. Zunächst und im Wesentlichen ist vorgesehen, dass die Gaseinlasskammern zur Prozesskammer hin von Ringwänden verschlossen sind. Anders als im Stand der Technik sind alle drei übereinander angeordneten Gaseinlasskammern zur Prozesskammer hin von gasdurchlässigen Ringwänden verschlossen. Die Ringwände bestehen aber nicht aus einem porösen Material, sondern besitzen dicht nebeneinanderliegende Gasaustrittsöffnungen. Dies ist wesentlich, da sich herausgestellt hat, dass die porösen Wände zwar zu einer Homogenisierung des Gaseintrags in die Prozesskammer geführt hat, aber dass die feinen Öffnungen des porösen Körpers schnell verstopfen. Als Ursache für diese Verstopfung werden hohe Temperatur- und Geschwindigkeitsgradienten im porösen Körper verantwortlich gemacht. Wesentlich ist ferner, dass die übereinander angeordneten, die Ringwände bildenden Ringkörper einen einheitlichen Außendurchmesser besitzen. Das gesamte, von oben in die Prozesskammer hineinragende Gaseinlassorgan hat somit die äußere Form eines Kreiszylinders. Es gibt keine Teile, die über die Mantelfläche dieses Zylinders hinausragen. Die Ringwände ragen somit vorsprungsfrei in die Prozesskammer hinein. Dies dient der Minimierung von Geschwindigkeitsgradienten in dem aus dem Gaseinlassorgan austretenden Prozessgasstrom. Die Ränder der Gasaustrittsöffnungen bilden somit erfindungsgemäß die einzigen Abrisskanten der Außenwandung. Die Ränder verlaufen dabei lediglich auf geraden oder gerundeten Abschnitten. Die Konturlinie der Ränder verläuft somit knickstellenfrei. Die Gasaustrittsöffnungen bilden Fenster aus. Sie besitzen im Wesentlichen eine konstante Öffnungsfläche, die über die gesamte Materialstärke des Ringkörpers von der Innenwandung hin zur Ausßenwandung konstant bleibt. Diese Fenster besitzen somit geradlinig verlaufende Laibungen. Das Absolutmaß der Öffnungsflächen besitzt einen optimalen Bereich. Optimal ist es, wenn die Flächen der Gasaustrittsöffnungen im Bereich zwischen 2 mm² und 6 mm² liegen. Optimal ist es ferner, wenn die Gasaustrittsöffnungen länglich gestaltet sind. Die Spaltweite kann dabei zwischen 0,2 und 1,5 mm liegen. Die Austrittsöffnungen der Ringwände, die der Decke bzw. dem Boden der Prozesskammer benachbart sind, haben bevorzugt eine größere Schlitzweite als diejenigen der mittleren Ringwand. Während die Schlitzweite der Gasaustrittsöffnungen der mittleren Ringwand bevorzugt bei etwa 0,3 mm liegt, liegt die Schlitzweite der Gasaustrittsöffnungen der äußeren Ringwände bevorzugt bei etwa 1 mm. Auch das Weiten- / Längenverhältnis kann bei den verschiedenen Ringwänden verschieden sein. Das Verhältnis von Weite zu Länge hängt im Wesentlichen von der Molmasse/min der in die Prozesskammer einzuleitenden Prozessgase ab. Wird AsH₃ bzw. PH₃ verwendet, liegt das Weiten- / Längenverhältnis bei etwa 0,3. Bei der Verwendung von NH₃ liegt es bei etwa 0,2. Für das reine Trägergas - Wasserstoff oder Stickstoffoder im Trägergas gelöste metallorganische Komponenten liegt das Verhältnis von Schlitzweite zu Schlitzlänge im Bereich zwischen 0,05 und 0,2. Bevorzugt liegt es bei etwa 0,05 für Wasserstoff und bei etwa 0,2 für Stickstoff.

Die Gasaustrittsöffnungen können grundsätzlich quadratische oder kreisrunde Querschnitte aufweisen. Es hat sich jedoch herausgestellt, dass diese Querschnitte optimierbar sind. Das Verhältnis von Länge und Weite der Öffnungsflächen sollte im Bereich zwischen 2 und 6, bzw. im Bereich zwischen 3 und 5 liegen, so dass langgestreckte Öffnungsquerschnitte entstehen. Vorteilhaft ist es auch, wenn die Öffnungsfläche ein Längen-/Breitenverhältnis besitzt, welches größer ist als 3. Theoretische Überlegungen, Modellrechnungen und Experimente haben gezeigt, dass unter diesen Voraussetzungen die Rückströmung von der Prozesskammer in die Gaseinlasskammer minimiert ist. Die in Strömungsrichtung geradlinig durchströmten Gasaustrittsöffnungen sind bevorzugt gleichmäßig über die Oberfläche der Ringkörper verteilt angeordnet. Sie werden bevorzugt geradlinig in Radialrichtung vom Prozessgas durchströmt, so dass das Prozessgas keine Richtungsumlenkung erfährt. Sie besitzen eine knickstellenfreie Umrisskontur. Von technologischer Relevanz ist ferner die Summe der Öffnungsflächen. Diese sollte im Bereich zwischen 15 % und 50 % der Gesamtaußenfläche der Ringwände liegen. Die Porosität, also das Verhältnis zwischen Summe der Öffnungsflächen und Gesamtfläche hängt aber auch von den zu verwendenden Prozessgasen ab. Durch die zuoberst liegenden Austrittsöffnungen und die zuunterst liegende Austrittsöffnung sollen Hydride in die Prozesskammer eingeleitet werden. Werden AsH₃ bzw. PH₃ dadurch eingeleitet, werden Ringwände verwendet, die eine Porosität von etwa 25 % besitzen. Diese Ringwände erstrecken sich dann jeweils oben und unten über etwa 15 % der Prozesskammerhöhe. Bei der Verwendung von NH₃ beträgt die Porosität der oberen bzw. unteren Ringwand bevorzugt etwa 40 %. Die beiden Ringwände erstrecken sich dann jeweils über etwa 20 % der Prozesskammerhöhe. Über den Rest der Prozesskammerhöhe erstreckt sich die mittlere Zone, durch welche die metallorganische Verbindung und ein Trägergas in die Prozesskammer eingeleitet werden. Handelt es sich bei dem Trägergas um Wasserstoff, beträgt die Porosität bevorzugt 15 %. Die mittlere Ringzone erstreckt sich dann über etwa 70 % der Reaktorhöhe. Wird als Trägergas Stickstoff verwendet, so liegt die Porosität etwa bei 40 %. Die mittlere Ringzone erstreckt sich dann über etwa 60 % der Reaktorhöhe. Ferner ist es von Vorteil, wenn sich die länglichen Gasaustrittsöffnungen vertikal übereinander überlappen. Auf diese Weise bildet sich eine Bernoulli-Sperre aus. Die Verwirbelung und damit einhergehenden Geschwindigkeitsgradienten in vertikaler Richtung werden damit wirksam vermieden. Ferner ist es von Vorteil, wenn die länglichen Gasaustrittsöffnungen in einem Winkel von 20° bis 60°, bevorzugt 30° bis 45°, geneigt zur Vertikalen verlaufen. Die Schlitze verlaufen bevorzugt in Form eines Fischgrätmusters übereinander. Hierdurch wird eine sogenannte durchgehende vertikale Bernoulli-Pumpe vermieden. Der Abstand zweier benachbarter Gasaustrittsöffnungen ist so gewählt, dass er geringer ist als die Länge der Gasaustrittsöffnungen. Bevorzugt liegt dieser Abstand zwischen 0,5 mm und 2 mm. Optimal ist eine Schlitzweite von etwa 1 mm. Die Höhenaufteilung der Gasauslasszonen, also der Ringflächen, erfolgt bevorzugt symmetrisch derart, dass die obere und die untere Gaseinlasszone dieselbe Höhe besitzen. Das Material für die Ringkörper kann Quarz oder Graphit sein. Die einzelnen Gaseinlasskammern werden wie auch beim Stand der Technik von kreisscheibenförmigen Horizontalstegen voneinander getrennt. Die äußere Umrisskontur eines derartigen kreisscheibenförmigen Horizontalsteges verläuft auf einer Kreisbogenlinie. Auf dem Rand der Horizontalstege stützen sich bevorzugt die Ringkörper ab. In einer bevorzugten Ausgestaltung ist das Gaseinlassorgan mit der Deckenplatte, die die Decke der Prozesskammer ausbildet, fest verbunden. Wird die Deckenplatte geöffnet, wird das Gaseinlassorgan aus der Prozesskammer genommen. Eine zum Suszeptor hin weisende Stirnseite des Gaseinlassorganes liegt bevorzugt innerhalb einer im Zentrum des Suszeptors angeordneten Vertiefung. Die Stirnseite, die der untersten Gaseinlasskammer zugeordnet ist, ist bevorzugt gekühlt. Hierzu besitzt der die Stirnseite ausbildende, tellerartige Horizontalsteg eine Kühlmittelkammer, die von einem Kühlmittel durchströmt werden kann. Die Tiefe der Aussparung, in welche die Stirnseite des Gaseinlassorganes eintritt, ist so bemessen, dass die obere Wandung des untersten Horizontalsteges mit der Oberseite des Suszeptors fluchtet. Auch die oberste Gaseinlasskammer wird von einem sich in Vertikalrichtung erstreckenden obersten tellerförmigen Körper begrenzt. Dessen nach unten weisende Wandung fluchtet mit der nach unten weisenden Wandung der Prozesskammerdecke. Während mit Gaseinlassorganen des Standes der Technik ein Totalgasfluss von maximal 50 slm bei einem Totaldruck von 200 mbar erreichbar ist, ist mit der modifizierten Gaseinlassorgangeometrie bei 100 slm Totalgasfluss bei einem Prozesskammerdruck von 400 mbar und mehr möglich. Der Durchmesser des Gaseinlassorganes liegt im Bereich zwischen 40 und 100 mm. Es hat sich herausgestellt, dass bei einem kleinen Durchmesser der Ringwände von 35 bis 50 mm, bevorzugt von etwa 40 mm, eine weitere Erhöhung sowohl des Totalflusses als auch des Totaldrucks möglich ist. Gestaltet man zudem die Gaseinlasskammern derart, dass ihre vertikale Höhe überproportional mit dem radialen Abstand vom Zentrum zunimmt, sind Totaldrücke von 800 mbar bei einem Betrieb mit mehr als 250 slm Totalgasfluss möglich. Die Prozesskammer kann dabei einen Durchmesser von mehr als 600 mm aufweisen. Die Prozesskammer der erfindungsgemäßen Vorrichtung hat daher vorzugsweise einen Durchmesser zwischen 500 mm und 700 mm. Die Höhe der Prozesskammer liegt dabei im Bereich von 25 bis 30 mm.

Ausführungsbeispiele der Erfindung werden nachfolgend anhand beigefügter Zeichnungen erläutert. Es zeigen:
- Fig. 1: einen Diagonalschnitt durch einen MOCVD-Reaktor eines ersten Ausführungsbeispiels der Erfindung, wobei zum Zwecke der Übersichtlichkeit für die unmittelbare Erläuterung des Erfindungsgedankens nicht notwendige Details entweder weggelassen oder grob schematisiert dargestellt sind,
- Fig. 2: eine vergrößerte Darstellung des Gaseinlassorganes der Vorrichtung gemäß Fig. 1,
- Fig. 3: einen weiter vergrößerten Ausschnitt des Gaseinlassorganes gemäß Fig. 1 im Bereich der Gaseinlasskammern,
- Fig. 4: den vergrößerten Bereich IV in Fig. 3 und
- Fig. 5: ein Gaseinlassorgan eines zweiten Ausführungsbeispiels in einer Darstellung gemäß Fig.1.

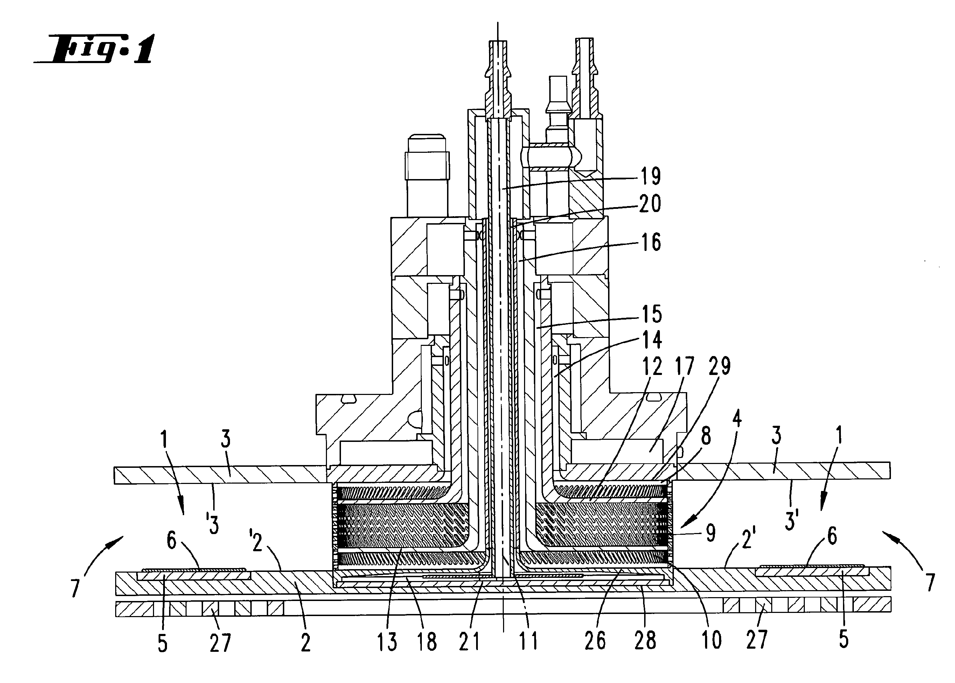

In einem nicht dargestellten äußeren Gehäuse, welches vakuumdicht ist und mit einer Vakuumpumpe verbunden ist, befindet sich die eigentliche Prozesskammer 1. Sie ist in der Fig. 1 der Übersicht halber mit einem verminderten Durchmesser dargestellt, um die konstruktiven Details des Gaseinlassorganes 4 übersichtlicher darstellen zu können.

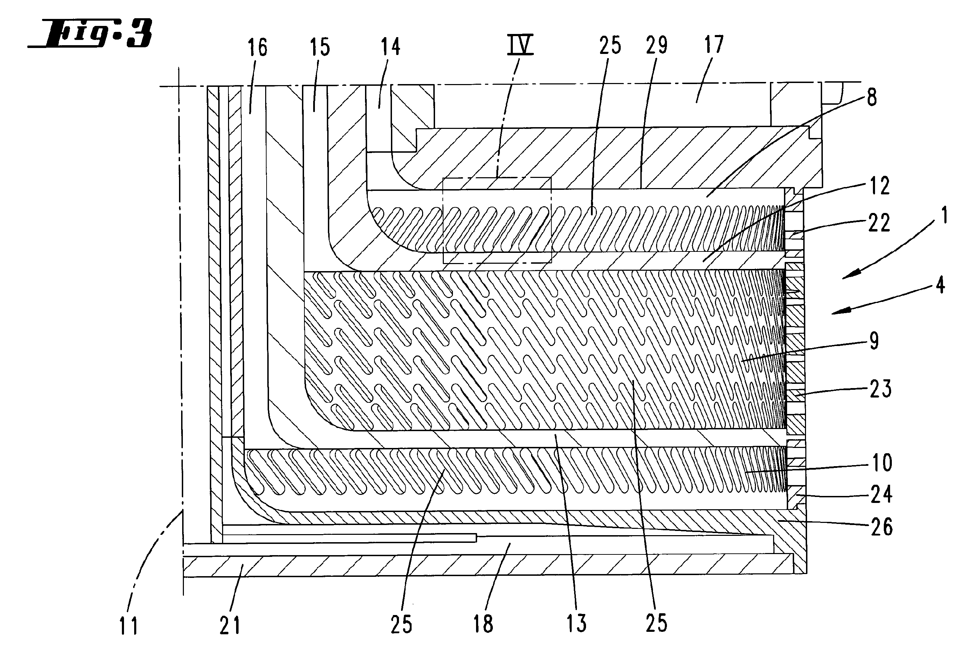

Der Boden 2' der Prozesskammer 1 wird von einem aus Quarz oder aus Graphit bestehenden Suszeptor 2 ausgebildet. Es handelt sich dabei um einen plattenförmigen Körper mit einem Durchmesser zwischen 500 mm und 700 mm. Im Zentrum dieser kreisscheibenförmigen Platte befindet sich eine Aussparung 28, die beim ersten Ausführungsbeispiel einen Innendurchmesser von etwa 60 bis 100 mm besitzt. Um diese zentrale Aussparung ist ringförmig um das Zentrum 11 eine Vielzahl von Substrathaltern 5 angeordnet, die jeweils in Aussparungen einliegen, kreisscheibenförmig gestaltet sind und von einem Gasstrom drehangetrieben werden. Hinsichtlich der Anordnung wird auf die Fig. 3 der DE 10 2004 009 130 A1 verwiesen.

Oberhalb des Suszeptors 2 erstreckt sich eine aus Graphit oder Quarz bestehende Prozesskammerdecke 3, die mit ihrer zum Suszeptor 2 hin weisenden Unterseite die Deckenwandung 3' der Prozesskammer ausbildet. Der Außendurchmesser der Prozesskammerdecke 3 entspricht im Wesentlichen dem Außendurchmesser des Suszeptors 2. Der Abstand der parallel zueinander verlaufenden Platten 2, 3, welcher die Prozesskammerhöhe definiert, beträgt etwa 30 mm.

Im Zentrum der Prozesskammerdecke 3 befindet sich eine Öffnung, durch welche das Gaseinlassorgan 4 in die Prozesskammer 1 hineinragt. Die Prozesskammerdecke 3 kann vom Gaseinlassorgan 4 getragen werden. Der in die Prozesskammer 1 hineinragende, zylindrische Abschnitt des Gaseinlassorganes 4 besitzt einen Durchmesser, der dem Durchmesser der Aussparung 28 entspricht. Die Stirnseite 21 des Gaseinlassorganes 4 liegt innerhalb der Aussparung 28, und zwar deren Boden gegenüber. Die sich in Radialrichtung unmittelbar an die Außenwandung des zylinderförmigen Gaseinlassorganes 4 anschließende Zone der Prozesskammer 1 bildet eine Gaseinlasszone, in welche Prozessgase aus der gasdurchlässigen Zylindermantelwand des Gaseinlassorganes 4 in die Prozesskammer eingeleitet werden. Die Prozessgase durchströmen dabei in Radialrichtung die Prozesskammer 1, wobei sich von einem Trägergas transportierte Verbindungen der Gruppe III und Gruppe V bzw. Gruppe II und Gruppe VI pyrolytisch zerlegen. Die Zerlegungsprodukte werden auf den auf den Substrathaltern 5 aufliegenden Substraten abgeschieden. Das Restgas tritt durch den mit der Bezugsziffer 7 gekennzeichneten Gasauslassbereich in Radialrichtung aus der Prozesskammer 1 aus.

Der in die Prozesskammer 1 hineinragende zylinderförmige Abschnitt des Gaseinlassorganes 4 besitzt drei vertikal übereinander liegende Gaseinlasskammern 8, 9,10. Die übereinander liegenden Gaseinlasskammern 8, 9,10 sind untereinander durch tellerförmige, sich in der Horizontalebene erstreckende Horizontalstege 12,13 voneinander getrennt. Die Stirnseite 21 des Gaseinlassorganes 4, welche eine von einem Kühlmittel durchströmbare Kühlmittelkammer 18 aufweist, bildet einen untersten Horizontalsteg. Die obere Wandung 29 der obersten Gaseinlasskammer 8 wird ebenfalls von einem Horizontalsteg gebildet. Letzterer verlängert sich in Radialrichtung zur Prozesskammerdecke 3.

Die zuoberst liegende Gaseinlasskammer 8 ist mittels einer Zuleitung 40 mit einer Trägergasquelle und einer Hydridquelle verbunden. Bei dem Trägergas kann es sich um Wasserstoff, Stickstoff oder einem Edelgas handeln. Bei dem Hydrid kann es sich um AsH₃, PH₃ oder bevorzugt NH₃ handeln. Diese Gasmischung strömt durch die Zuleitung 14 in die Gaseinlasskammer 8 ein. Zur Prozesskammer 1 hin ist die Gaseinlasskammer 8 von einer ringförmigen Wandung umgeben. Der diese Wandung ausbildende Ringkörper 22 kann aus Quarz oder aus Graphit bestehen und stützt sich auf dem äußeren Rand des Horizontalsteges 12 ab. Der Ringkörper 22 besitzt eng benachbarte, die Form von Längsschlitzen aufweisende Austrittsöffnungen 25, die schräg verlaufen. Die parallel zueinander verlaufenden Austrittsöffnungen 25 bilden eine stegunterbrochene Ringöffnung.

Unterhalb der obersten Gaseinlasskammer 8 befindet sich eine etwa doppelt so hohe Gaseinlasskammer 9, die mit einer Zuleitung 15 verbunden ist. Die Zuleitung 15 ist mit einer Trägergasquelle und mit einer Quelle eines metallorganischen Ausgangsstoffes verbunden. Bei dem metallorganischen Ausgangsstoff kann es sich um TMGa, TMIn oder TMAl handeln. Letzterer wird zusammen mit dem Trägergas durch die Zuleitung 15 in die Gaseinlasskammer 9 transportiert. Auch diese Gaseinlasskammer 9 ist von einem Ringkörper 23 umgeben, dessen Wandung schräge Längsschlitze als Austrittsöffnungen aufweist. Hier liegen mehrere Reihen von stegunterbrochenen Austrittsöffnungen 25 übereinander, wobei sich die einzelnen Austrittsöffnungen nicht nur vertikal übereinander, sondern auch in Horizontalrichtung überlappen. Die Größe dieser Austrittsöffnungen 25 entspricht der Größe der Austrittsöffnungen 25 des oberen Ringkörpers 22. Allerdings ist der Neigungswinkel der Austrittsöffnungen des mittleren Ringkörpers 23 gegenüber dem Neigungswinkel der Austrittsöffnungen 25 des oberen Ringkörpers und eines unteren Ringkörpers 24 entgegengesetzt.

Mittels eines weiteren Horizontalsteges 13 ist die mittlere Gaseinlasskammer 9 von einer unteren Gaseinlasskammer abgetrennt. Die untere Gaseinlasskammer 10 ist mit einer Zuleitung 16 verbunden. Die Zuleitung 16 ist wiederum mit einer Trägergasquelle und einer Hydridquelle verbunden. Das Trägergas und das damit transportierte Hydrid wird durch die Zuleitung 16 in die Gaseinlasskammer 10 transportiert und tritt durch Gasaustrittsöffnungen 25, die denjenigen des obersten Ringkörpers 22 gleichgestaltet sind, aus dem untersten Ringkörper 24 in die Prozesskammer ein. Die zur Gaseinlasskammer 10 hin weisende Wandung des Horizontalsteges 26 fluchtet dabei im Wesentlichen mit der Oberfläche 2' des Suszeptors 2.

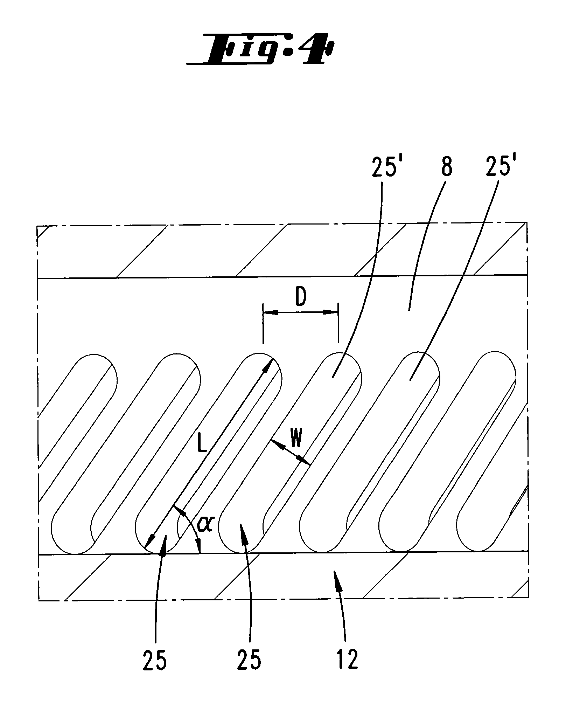

Die Fig. 4 zeigt am Beispiel des obersten Ringkörpers 22 die Ausgestaltung und die Anordnung von Austrittsöffnungen 25, wie sie auch im mittleren Ringkörper 23 und im unteren Ringkörper 24 vorgesehen sind. Die Austrittsöffnungen 25 haben die Form von Langlöchern mit parallel zueinander und geradlinig verlaufenden Randabschnitten, die sich entlang der Längsrichtung L erstrecken. Die Länge L der Austrittsöffnungen liegt im Bereich von 2 mm bis 20 mm. Die Weite W der Austrittsöffnungen 25 liegt im Bereich von 0,2 mm bis 1,5 mm. Es hat sich als vorteilhaft herausgestellt, wenn das Verhältnis von L/W größer als 3 bzw. im Bereich von 3 bis 5 liegt. Der Scheitelabstand D zweier nebeneinander liegender Austrittsöffnungen 25 ist so gewählt, dass der die beiden Längsseiten zweier benachbarter Austrittsöffnungen 25 trennende Steg eine Breite besitzt, die in der Größenordnung der Weite W bzw. etwa der Größe der Weite W entspricht. Die Schmalseiten der Austrittsöffnungen 25 verlaufen auf einer gerundeten Konturlinie und insbesondere auf einer Kreisbogenlinie. Die Austrittsöffnungen 25 erstrecken sich in Radialrichtung geradlinig. Die oben beschriebene Flächenkontur besteht aus zwei sich gegenüberliegenden Halbkreisen und zwei sich gegenüberliegenden geradlinigen Verbindungen der beiden Halbkreise. Der Durchmesser der Halbkreise entspricht dabei der Weite W der Austrittsöffnung 25. Jede Austrittsöffnung 25 erstreckt sich mit gleichbleibender Querschnittsfläche und gleichbleibender Umrisskontur durch die gesamte Materialstärke eines jeden Ringkörpers 22, 23, 24. Die Öffnungen 25 können bspw. durch Laserschneiden erzeugt werden. Infolge dessen verlaufen die Wandungen 25' der Austrittsöffnungen 25 geradlinig.

Insgesamt ist die Vielzahl der Austrittsöffnungen 25 gleichmäßig über die gesamte Umfangsfläche des zylinderförmigen Abschnitts des Gaseinlassorganes 4 verteilt. Sämtliche übereinander angeordneten Ringkörper 22, 23, 24 haben gleiche Innen- und Außendurchmesser. Die gesamte von den Austrittsöffnungen 25 ausgebildete Öffnungsfläche entspricht etwa 20 % bis 50 % der gesamten Mantelfläche des zylinderförmigen Abschnittes 5, also der Mantelfläche der Ringkörper 22, 23, 24.

Um sicherzustellen, dass innerhalb der Gaseinlasskammern 8, 9,10 keine unerwünschte Vorzerlegung der Precursor, also AsH₃, PH3, NH₃, TMGa, TMIn und TMAl, stattfindet, wird der in die Prozesskammer 1 hineinragende Abschnitt des Gaseinlassorganes 4 nicht nur im Bereich der Stirnseite 21 gekühlt, nämlich mittels durch die Kühlkanäle 19, 20 in die Kühlkammer 18 einströmendes flüssiges Kühlmittel, sondern auch mittels einer Kühlmittelkammer 17, die oberhalb der obersten Gaseinlasskammer 8 angeordnet ist. Auch letztere wird von einem Kühlmittel durchströmt.

Die Beheizung der Prozesskammer 1 erfolgt von unten mittels einer mit der Bezugsziffer 27 bezeichneten und lediglich schematisch dargestellten Heizung. Letztere kann eine Vielzahl von spiralförmig angeordneten Windungen aufweisen, die von einer IR-Heizung oder von einer Widerstandsheizung gebildet sind. Über Strahlung oder Wirbelströme wird der Suszeptor 2 beheizt. Das Prozessgas innerhalb der Prozesskammer 1 wird ebenfalls aufgeheizt. Durch Wärmeleitung und Wärmestrahlung heizt sich auch die Prozesskammerdecke 3 auf.

Die Zuleitungen 14,15 und 16 verlaufen quer zur Erstreckungsrichtung der Prozesskammer 1, also in Vertikalrichtung koaxial zueinander. Über nicht dargestellte Leitungen sind sie mit den oben beschriebenen Gasquellen eines Gasversorgungssystems verbunden. Dort können die Flussraten eingestellt werden.

Zum Abscheiden einer GaN-Bufferschicht auf einem Al₂O₃-Substrat wird der Suszeptor 2 derart aufgeheizt, dass die Oberfläche des Substrates 6 eine Temperatur erreicht, die etwa bei 1200°C liegt. Bei einem Totaldruck von 400 mbar strömen insgesamt mehr als 100 slm an Prozessgas aus dem Gaseinlassorgan 4 in die Prozesskammer 1. Es wird mit TMGa-Flussraten von mehr als 2,5 mmol/min bis zu 3,5 mmol/min gearbeitet. Unter diesen Prozessbedingungen wird auf das Substrat bzw. auf eine zuvor auf dem Substrat abgeschiedene Nukleationsschicht GaN abgeschieden. Unter Verwendung von NH₃ als V-Komponente werden dabei Wachstumsraten von 6 µm pro Stunde und mehr erzielt.

Die Gasaustrittsfläche der Ringkörper 22, 23, 24 ist zufolge der zuvor beschriebenen Maßnahmen dahingehend optimiert, dass dort nur minimale Temperatur- und Geschwindigkeitsgradienten auftreten. Die Abrisskanten, an denen sich Wirbel oder andere die Homogenität des Gasstromes beeinflussenden Effekte ausbilden können, sind minimiert. Die im Wesentlichen oval verlaufenden Ränder der Austrittsöffnungen 25 bilden die einzigen Abrisskanten. Obwohl nicht nur unmittelbar benachbart der Ringkörper 22, 23, 24, sondern auch unterhalb der Prozesskammerdecke 3 Temperaturbedingungen herrschen, die grundsätzlich eine Nukleation zulassen, wird letztere wirksam durch die Geometrie und Anordnung der Austrittsöffnungen 25 unterbunden.

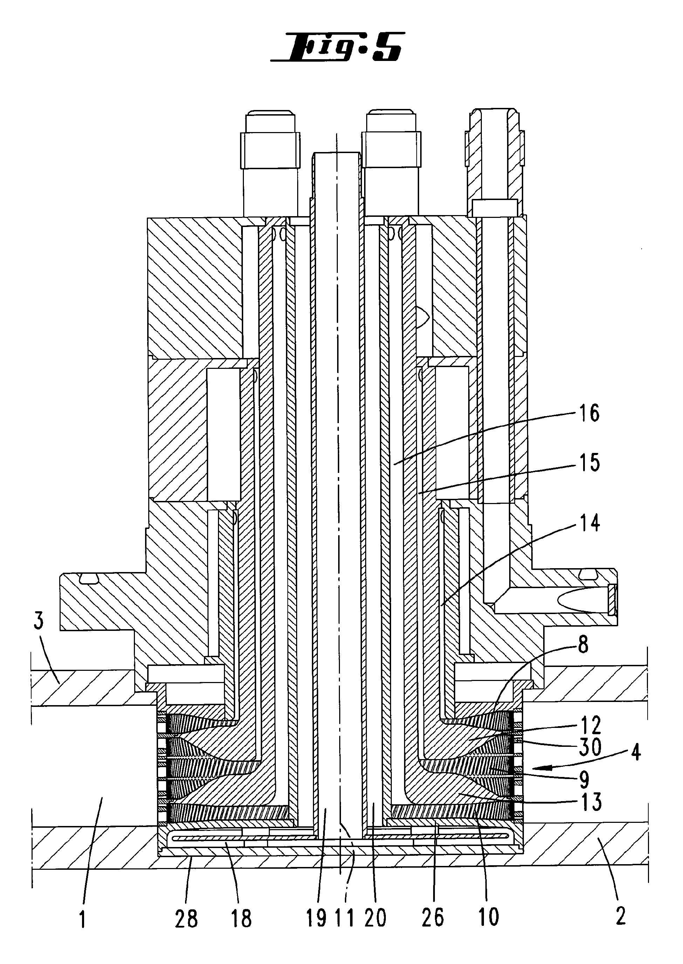

Die Fig. 5 zeigt eine weitere Verbesserung der Geometrie des Gaseinlassorganes 4, mit der sich der Bereich, in dem die Wachstumsrate linear vom TMGa-Fluss abhängt, noch weiter vergrößert und damit die Effizienz des Reaktors gesteigert wird.

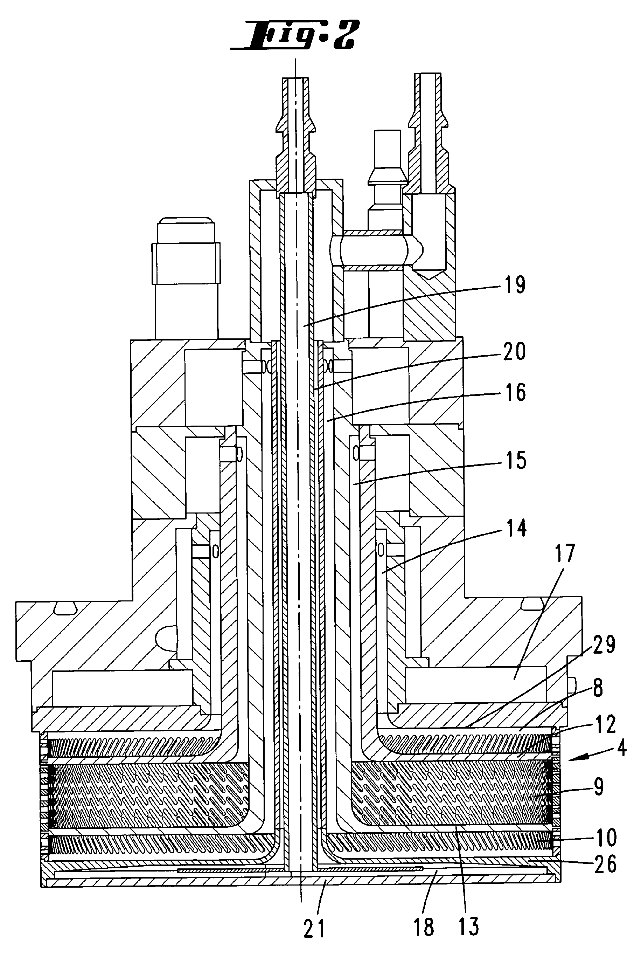

Der in Fig. 5 dargestellte zylinderförmige Abschnitt des Gaseinlassorganes 4 besitzt einen verminderten Durchmesser, nämlich etwa 40 mm. Anders als bei dem in den Figuren 1 bis 3 dargestellten Gaseinlassorgan 4 sind hier die horizontalen Wandungen der Gaseinlasskammern 8, 9,10 gewölbt. Die Höhe der Gaseinlasskammern 8, 9,10 nimmt hier stetig in Radialrichtung vom Zentrum 11 bis zu den Ringkörpern 22, 23, 24 zu. Die Zunahme ist überproportional, so dass die Gasgeschwindigkeit in Radialrichtung innerhalb der Gaseinlasskammern 8, 9,10 im Wesentlichen konstant ist.

Die Auslegung der die Austrittsöffnungen 25 ausbildenden Schlitze, deren Anordnung auf der Wandung der Gaseinlasskammern 8, 9, 10 und deren Beabstandung hängt von dem durch die jeweilige Gaseinlasszone in die Prozesskammer einzuleitenden Prozessgas ab. Die Schlitze sind bevorzugt in einem Winkel von 30° bis 45° gegenüber der Vertikalen geneigt. Damit ist eine Porosität, also ein Verhältnis von Summe aller Öffnungen zur Gesamtfläche von 15 % bis 50 % fertigbar. Die Porosität wird in Verbindung mit der vertikalen Höhe der Gaseinlasszonen nach der Molmasse/ min der Prozessgase ausgelegt. Bei der Verwendung von AsH₃ bzw. PH₃ als Hydrid beträgt die Porosität der oberen und unteren Wandung der Gaseinlasskammern 8,10 etwa 25 %. Die Höhe der Gaseinlasskammer 8,10 beträgt dabei etwa 15 % der Prozesskammerhöhe. Bei der Verwendung von NH₃ betragen die Porositäten der Wände der Gaseinlasskammern 8,10 etwa 40 %. Die jeweilige Gaseinlasskammer erstreckt sich dann über 20 % der vertikalen Höhe der Prozesskammer. Die mittlere Einlasszone 9 für die metallorganische Verbindung besitzt eine Porosität von 15 % und erstreckt sich über 70 % der Gesamtaustrittsfläche, wenn als Trägergas Wasserstoff verwendet wird. Wird als Trägergas Stickstoff verwendet, so soll die Porosität der Wandung der mittleren Gaseinlasszone 9 etwa 40 % betragen. Die gesamte Ringfläche der mittleren Gaseinlasskammer 8 erstreckt sich dann über 60 % der Gesamtauslassfläche.

Bezogen auf die vertikal übereinanderliegenden Gaseinlasskammern 8, 9, 10 sollen die Schlitze als Fischgrätmuster übereinander angeordnet sein. Sie sollen somit wechselseitig in die jeweils andere Richtung geneigt sein.

Auch das Weiten- / Längenverhältnis der Schlitze hängt von den Molmassen/min ab. Bei der Verwendung von AsH₃ bzw. PH₃ beträgt das Weiten- / Längenverhältnis etwa 0,3, bei der Verwendung von NH₃ etwa 0,2, bei der Verwendung von Wasserstoff etwa 0,05 und bei der Verwendung von Stickstoff etwa 0,2. Der Abstand zwischen den einzelnen Schlitzen liegt typischerweise bei 1 mm. Die Höhenaufteilung der Einlasszonen in der Prozesskammer erfolgt symmetrisch.

In den Ausführungsbeispielen sind die Gaseinlasskammern 8, 9,10 offene Hohlräume. In diesen Hohlräumen kann sich, insbesondere wegen eines gekrümmten Verlaufs der Wände der Gaseinlasskammern, ein hauptsächlich parabolisches Strömungsprofil ausbilden. Im nicht dargestellten Ausführungsbeispiel können sich in den Gaseinlasskammern 8, 9,10 stromaufwärts der Ringwände 22, 23, 24 Strömungsbarrieren befinden. Derartige Strömungsbarrieren können von porösen Körpern, Gittern oder dergleichen gebildet sein. Diese zusätzlichen Barrieren vergleichmäßigen das Strömungsprofil und verhindern die Ausbildung von Jets.

## Patentansprüche

1. Vorrichtung zum Abscheiden von Schichten, insbesondere Halbleiterschichten mit einer im Wesentlichen rotationssymmetrisch um ein Zentrum (11) angeordneten Prozesskammer (1),
die einen von einem in einer Horizontalebene angeordneten Suszeptor (2) ausgebildeten Boden,
eine vertikal oberhalb des Suszeptors (2) angeordnete Prozesskammerdecke (3),
eine im Zentrum (11) zwischen Suszeptor (2) und Prozesskammerdecke (3) sich erstreckendes Gaseinlassorgan (4) mit vertikal übereinander angeordneten Gaseinlasskammern (8, 9,10) und
eine vertikal unterhalb des Suszeptors (2) angeordnete Heizung (27) zum Aufheizen des Suszeptors (2) aufweist,
wobei auf dem Suszeptor (2) eine Vielzahl von mit Abstand zum Gaseinlassorgan (4) angeordnete Substrathalter (5) zur Aufnahme von zu beschichtenden Substraten (6) vorgesehen sind,
wobei eine oberste (8) der Gaseinlasskammern unmittelbar der Prozesskammerdecke (3) benachbart und mit einer Zuleitung (14) zum Einleiten eines Hydrides zusammen mit einem Trägergas in die Prozesskammer (1) verbunden ist,
wobei eine unterste (10) der Gaseinlasskammern unmittelbar dem Suszeptor (2) benachbart und mit einer Zuleitung (16) zum Einleiten eines Hydrides zusammen mit einem Trägergas in die Prozesskammer verbunden ist, wobei zumindest eine zwischen der untersten (10) und der obersten (8) Gaseinlasskammer angeordnete mittlere Gaseinlasskammer (9) mit einer Zuleitung (15) zum Einleiten einer metallorganischen Verbindung in die Prozesskammer (1) verbunden ist,
**dadurch gekennzeichnet, dass** die Gaseinlasskammern (8, 9, 10) zur Prozesskammer (1) hin von Ringwänden (22, 23, 24) verschlossen sind, wobei die Ringwände (22, 23, 24) eine Vielzahl von dicht nebeneinander liegenden Gasaustrittsöffnungen (25) aufweisen,
einen einheitlichen Außendurchmesser besitzen und eine im Wesentlichen vorsprungsfrei zur Prozesskammer (1) weisende Außenwandung besitzen.

2. Vorrichtung nach Anspruch 1, **dadurch gekennzeichnet, dass** zur Minimierung von Geschwindigkeitsgradienten in dem aus dem Gaseinlassorgan (4) austretenden Prozessgasstrom die Ränder der Gasaustrittsöffnungen (25) die einzigen Abrisskanten der Außenwandung sind und entlang einer lediglich gerade oder gerundete Abschnitte aufweisenden Konturlinie knickstellenfrei verlaufen.

3. Vorrichtung nach einem der vorhergehenden Ansprüche, **dadurch gekennzeichnet, dass** sich die Gasaustrittsöffnungen (25) im Wesentlichen geradlinig mit konstanter Öffnungsfläche von der zur Gaseinlasskammer (8, 9,10) weisenden Innenwandung zur Außenwandung der zugehörigen Ringwand (22, 23, 24) erstrecken.

4. Vorrichtung nach Anspruch 3, **dadurch gekennzeichnet, dass** die Öffnungsflächen der im Wesentlichen identisch gestalteten Gasaustrittsöffnungen im Bereich zwischen 2 mm² und 5 mm² liegen.

5. Vorrichtung nach einem der vorhergehenden Ansprüche, **dadurch gekennzeichnet, dass** das Verhältnis von Länge (1) und Weite (w) der Öffnungsflächen im Bereich zwischen 2 und 6 bevorzugt zwischen 3 und 5 liegt und besonders bevorzugt 4 beträgt.

6. Vorrichtung nach einem der vorhergehenden Ansprüche, **dadurch gekennzeichnet, dass** die Summe der Öffnungsflächen der Gasaustrittsöffnungen (25) zwischen 15 % und 50 % der Gesamtaußenfläche der Ringwände (22, 23, 24) beträgt.

7. Vorrichtung nach einem der vorhergehenden Ansprüche, **dadurch gekennzeichnet, dass** die länglichen Gasaustrittsöffnungen (25) in einem Winkel zwischen 30 und 60 Grad geneigt zu einer Vertikalen verlaufen.

8. Vorrichtung nach einem der vorhergehenden Ansprüche, **dadurch gekennzeichnet, dass** die Gasaustrittsöffnungen (25) einer Ringwand (23) in mehreren Reihen übereinander angeordnet sind, wobei sich die Gasaustrittsöffnungen (25) verschiedener Reihen in Vertikalrichtung überlappen, wobei der Abstand (d) zweier benachbarter Gasaustrittsöffnungen (25) so gewählt ist, dass sich die beiden benachbarten Gasaustrittsöffnungen (25) in Vertikalrichtung überlappen.

9. Vorrichtung nach einem der vorhergehenden Ansprüche, **dadurch gekennzeichnet, dass** die Ringwände von Ringkörpern (22, 23, 24) gebildet sind, die aus Quarz oder Graphit bestehen, die auf den Rändern von kreisscheibenförmigen Horizontalstegen (12,13,26) aufliegen.

10. Vorrichtung nach Anspruch 9, **dadurch gekennzeichnet, dass** eine insbesondere eine Kühlmittelkammer (18) aufweisende Stirnseite (21) des Gaseinlassorganes (4) in einer zentralen Aussparung des Suszeptors (2) derart einliegt, dass der die unterste Gaseinlasskammer (10) zur Stirnseite (21) hin begrenzende Horizontalsteg (26) mit der zur Prozesskammer (1) hin weisenden Oberfläche (2') des Suszeptors (2) fluchtet.

11. Vorrichtung nach einem der vorhergehenden Ansprüche, **dadurch gekennzeichnet, dass** die obere Wandung (29) der obersten Gaseinlasskammer (8) mit der zur Prozesskammer (1) hin weisenden Unterseite (3') der Prozesskammerdecke (3) fluchtet.

12. Vorrichtung nach einem der vorhergehenden Ansprüche, **dadurch gekennzeichnet, dass** bei einem Durchmesser der Prozesskammer im Bereich zwischen 500 bis 700 mm der einheitliche Außendurchmesser der Ringwände (22, 23, 24) 35 bis 50 mm beträgt und die Höhe der Prozesskammer (1) 25 bis 30 mm beträgt.

13. Vorrichtung nach einem der vorhergehenden Ansprüche, **dadurch gekennzeichnet, dass** die Höhe der Gaseinlasskammern (8, 9,10) in Stromrichtung des Gases ansteigt.

14. Vorrichtung nach einem der Ansprüche 9 bis 13, gekennzeichnet durch einen glattwandig gewölbten Verlauf der zu den Gaseinlasskammern (8, 9,10) hin weisenden Oberflächen der Horizontalstege (12,13,26).

15. Verwendung einer Vorrichtung gemäß einem der vorhergehenden Ansprüche zum Abscheiden von Halbleiterschichten, wobei durch die Gasaustrittsöffnungen (25) der obersten Gaseinlasskammer (8) und durch die Gasaustrittsöffnungen (25) der untersten Gaseinlasskammer (10) zusammen mit einem Trägergas ein Hydrid, beispielsweise NH₃, PH₃ oder AsH₃ und durch die Gasaustrittsöffnungen (25) der mittleren Gaseinlasskammer (9) eine metallorganische Verbindung, beispielsweise TMGa, TMIn oder TMAl in die durch die Heizung (27) aufgeheizte Prozesskammer eingeleitet werden, **dadurch gekennzeichnet, dass** der Gesamtstrom der durch die Gasaustrittsöffnungen (25) in die Prozesskammer eingeleiteten Gase größer ist als 100 slm, bevorzugt größer ist als 250 slm und dass der Totaldruck in der Prozesskammer größer ist als 400 mbar, bevorzugt größer ist als 800 mbar.

## Claims

1. A device for depositing layers, in particular semiconductor layers, comprising a process chamber (1) arranged substantially rotationally symmetrically about a center (11), the process chamber having a bottom formed by a susceptor (2) disposed in a horizontal plane,
a process chamber ceiling (3) disposed vertically above the susceptor (2), a gas inlet element (4) which extends in the center (11) between susceptor (2) and process chamber ceiling (3) and has gas inlet chambers (8, 9, 10) which are disposed vertically one above the other, and
a heater (27) disposed vertically below the susceptor (2), for heating the susceptor (2),
wherein, on the susceptor (2), a multiplicity of substrate holders (5) arranged spaced apart from the gas inlet element (4) are provided for accommodating substrates (6) to be coated,
wherein a topmost (8) of the gas inlet chambers is directly adjacent to the process chamber ceiling (3) and is connected to a feed line (14) for introducing a hydride together with a carrier gas into the process chamber (1), wherein a lowermost (10) of the gas inlet chambers is directly adjacent to the susceptor (2) and is connected to a feed line (16) for introducing a hydride together with a carrier gas into the process chamber,
wherein at least one middle gas inlet chamber (9) disposed between the lowermost (10) and the topmost (8) gas inlet chamber is connected to a feed line (15) for introducing an organometallic compound into the process chamber (1),
**characterized in that** the gas inlet chambers (8,9,10) are closed off toward the process chamber (1) by annular walls (22, 23, 24),
the annular walls (22, 23, 24) having a multiplicity of closely adjacent gas outlet openings (25),
having a uniform outer diameter, and
an outer wall which is substantially without projections and faces toward the process chamber (1).

2. The device according to claim 1, **characterized in that** for minimizing velocity gradients in the process gas flow exiting from the gas inlet element (4), the edges of the gas outlet openings (25) are the only stall edges of the outer wall and run kink-free along a contour line which has only straight or rounded portions.

3. The device according to any one of the preceding claims, **characterized in that** the gas outlet openings (25) extend substantially in a straight line with a constant opening area from the inner wall facing toward the gas inlet chamber (8, 9, 10) to the outer wall of the associated annular wall (22, 23,24).

4. The device according to claim 3, **characterized in that** the opening areas of the substantially identically configured gas outlet openings are in the range between 2 mm² and 5 mm².

5. The device according to any one of the preceding claims, **characterized in that** the ratio of length (1) and width (w) of the opening areas lies in the range between 2 and 6, preferably between 3 and 5, and particularly preferably, is 4.

6. The device according to any one of the preceding claims, **characterized in that** the sum of the opening areas of the gas outlet openings (25) amounts to between 15% and 50% of the total outer area of the annular walls (22, 23,24).

7. The device according to any one of the preceding claims, **characterized in that** the elongated gas outlet openings (25) extend inclined at an angle between 30 and 60 degrees with respect to a vertical.

8. The device according to any one of the preceding claims, **characterized in that** the gas outlet openings (25) of an annular wall (23) are arranged in a plurality of rows one above the other, the gas outlet openings (25) of different rows overlapping one another in the vertical direction, whereby the spacing (d) between two adjacent gas outlet openings (25) is selected such that the two adjacent gas outlet openings (25) overlap one another in the vertical direction.

9. The device according to any one of the preceding claims, **characterized in that** the annular walls are formed by annular bodies (22, 23, 24) consisting of quartz or graphite which rest on the edges of circular disk-shaped horizontal webs (12, 13, 26).

10. The device according to claim 9, **characterized in that** a front end (21) of the gas inlet element (4), which front end has in particular a coolant chamber (18), lies in a central cut-out of the susceptor (2) in such a manner that the horizontal web (26) delimiting the lowermost gas inlet chamber (10) toward the front end (21) is aligned with the surface (2') of the susceptor (2) that faces toward the process chamber (1).

11. The device according to any one of the preceding claims, **characterized in that** the upper wall (29) of the topmost gas inlet chamber (8) is aligned with the lower side (3') of the process chamber ceiling (3) that faces toward the process chamber (1).

12. The device according to any one of the preceding claims, **characterized in that** with a diameter of the process chamber in the range between 500 to 700 mm, the uniform outer diameter of the annular walls (22, 23, 24) is approximately 35 to 50 mm and the height of the process chamber (1) is approximately 25 to 30 mm.

13. The device according to any one of the preceding claims, **characterized in that** the height of the gas inlet chambers (8, 9,10) increases in the flow direction of the gas.

14. The device according to any one of the claims 9 to 13, **characterized by** a smooth-walled curved course of the surfaces of the horizontal web (12, 13, 26) that face toward the gas inlet chambers (8, 9,10).

15. Use of a device according to any one of the preceding claims for depositing semiconductor layers, wherein, through the gas outlet openings (25) of the topmost gas inlet chamber (8) and through the gas outlet openings (25) of the lowermost gas inlet chamber (10), together with a carrier gas, a hydride, for example NH₃, PH₃ or AsH₃, and through the gas outlet openings (25) of the middle gas inlet chamber (9), an organometallic compound, for example TMGa, TMIn or TMAl, are introduced into the process chamber heated by the heater (27), **characterized in that** the total gas flow of the gases introduced through the gas outlet openings (25) into the process chamber is greater than 100 slm, preferably greater than 250 slm, and that the total pressure in the process chamber is greater than 400 mbar, preferably greater than 800 mbar.

## Revendications

1. Dispositif pour déposer des couches, plus particulièrement de couches de semi-conducteurs, avec une chambre de traitement (1) disposée globalement avec une symétrie de rotation autour d'un centre (11),
qui comprend un fond constitué d'un suscepteur (2) disposé dans un plan horizontal,
un plafond de chambre de traitement disposée verticalement au-dessus du suscepteur (2),
un organe d'admission de gaz (4) s'étendant dans le centre (11) entre le suscepteur (2) et le plafond de la chambre de traitement (3) avec des chambres d'admission de gaz (8, 9, 10) disposée verticalement les unes sur les autres et
un chauffage (27) disposé verticalement en dessous du suscepteur (2) pour le chauffage du suscepteur (2),
une pluralité de supports de substrats (5), disposés à une certaine distance de l'organe d'amission de gaz (4), étant prévus sur le suscepteur (2) pour le logement de substrats (6) à revêtir,
la plus haute (8) des chambres d'amission de gaz étant directement adjacente au plafond de la chambre de traitement (3) et étant reliée à une conduite d'alimentation (14) pour l'introduction d'un hybride avec un gaz porteur dans la chambre de traitement (1),
la plus basse (10) des chambres d'amission de gaz étant directement adjacente au suscepteur (2) et étant reliée à une conduite d'alimentation (16) pour l'introduction d'un hybride avec un gaz porteur dans la chambre de traitement,
au moins une chambre d'admission de gaz centrale (9), disposée entre la chambre d'admission de gaz la plus basse (10) et la chambre d'admission de gaz la plus haute (8), étant reliée à une conduite d'alimentation (15) pour l'introduction d'un composé organométallique dans la chambre de traitement (1),
**caractérisé en ce que** les chambres d'admission de gaz (8, 9, 10) sont fermées par rapport à la chambre de traitement (1) par des parois annulaires (22, 23, 24),
les parois annulaires (22, 23, 24) comprenant une pluralité d'ouvertures de sortie de gaz (25) disposées de façon denses les unes contre les autres,
présentant un diamètre extérieur unique et
présentant une paroi extérieur orientée globalement sans saillies vers la chambre de traitement (1).

2. Dispositif selon la revendication 1, **caractérisé en ce que**, pour la réduction des gradients de vitesse dans le flux de gaz de traitement sortant de l'organe d'admission de gaz (4), les bords des ouvertures de sortie de gaz (25) sont les seules arêtes de contour de la paroi extérieure et s'étendent sans plis le long d'une ligne de contour comprenant uniquement des portions droites ou arrondies.

3. Dispositif selon l'une des revendications précédentes, **caractérisé en ce que** les ouvertures de sortie de gaz (25) s'étendent globalement de manière linéaire avec une surface d'ouverture constante de la paroi intérieure orientée vers la chambre d'admission de gaz (8, 9, 10) vers la paroi extérieure de la paroi annulaire (22, 23, 24) correspondante.

4. Dispositif selon la revendication 3, **caractérisé en ce que** les surfaces d'ouvertures des ouvertures de sortie de gaz, de formes globalement identiques, sont de l'ordre de 2 mm² à 5 mm².

5. Dispositif selon l'une des revendications précédentes, **caractérisé en ce que** le rapport entre la longueur (l) et la largeur (w) des surfaces d'ouvertures est de 2 à 6, de préférence de 3 à 5 et plus particulièrement de 4.

6. Dispositif selon l'une des revendications précédentes, **caractérisé en ce que** la somme des surfaces d'ouvertures des ouvertures de sortie de gaz (25) est de 15% à 50% de la surface extérieure totale des parois annulaires (22, 23, 24).

7. Dispositif selon l'une des revendications précédentes, **caractérisé en ce que** les ouvertures de sortie de gaz (25) oblongues sont inclinées d'un angle de 30 à 60 degrés par rapport à la verticale.

8. Dispositif selon l'une des revendications précédentes, **caractérisé en ce que** les ouvertures de sortie de gaz (25) d'une paroi annulaire (23) sont disposées sur plusieurs rangées les unes sur les autres, les ouvertures de sortie de gaz (25) de différentes rangées se superposant dans la direction verticale, la distance (d) entre deux ouvertures de sortie de gaz (25) adjacentes étant choisie de façon à ce que les deux ouvertures de sortie de gaz (25) adjacentes se superposent dans la direction verticale.

9. Dispositif selon l'une des revendications précédentes, **caractérisé en ce que** les parois annulaires sont constituées de corps annulaires (22, 23, 24), eux-mêmes constitués de quartz ou de graphite, qui sont posés sur les bords de nervures horizontales (12, 13, 26) en forme de disques.

10. Dispositif selon la revendication 9, **caractérisé en ce qu'**un côté frontal (21) de l'organe d'admission de gaz (4), comprenant plus particulièrement une chambre de fluide de refroidissement (18), se trouve dans un évidement central du suscepteur (2), **en ce que** la nervure horizontale (26) limitant la chambre d'admission de gaz (10) la plus basse en direction du côté frontal (21) est alignée avec la surface (2') du suscepteur (2) orientée vers la chambre de traitement (1).

11. Dispositif selon l'une des revendications précédentes, **caractérisé en ce que** la paroi supérieure (29) de la chambre d'admission de gaz (8) la plus haute est alignée avec le côté inférieur (3') du plafond de la chambre de traitement (3), orienté vers la chambre de traitement (1).

12. Dispositif selon l'une des revendications précédentes, **caractérisé en ce que**, pour un diamètre de la chambre de traitement de l'ordre de 500 à 700 mm, le diamètre extérieur unique des parois annulaires (22, 23, 24) est de 35 à 50 mm et la hauteur de la chambre de traitement (1) est de 25 à 30 mm.

13. Dispositif selon l'une des revendications précédentes, **caractérisé en ce que** la hauteur des chambres d'admission de gaz (8, 9, 10) augmente dans la direction d'écoulement du gaz.

14. Dispositif selon l'une des revendications 9 à 13, **caractérisé par** l'extension incurvée à parois lisses des surfaces des nervures horizontales (12, 13, 26) orientées vers les chambres d'admission de gaz (8, 9, 10).

15. Utilisation d'un dispositif selon l'une des revendications précédentes pour le dépôt de couches de semi-conducteurs, dans laquelle dans la chambre de traitement chauffée par le chauffage (27), sont introduits, à travers les ouvertures de sortie de gaz (25) de la chambre d'admission de gaz (8) la plus haute et à travers les ouvertures de sortie de gaz (25) de la chambre d'admission de gaz (10) la plus basse, un hybride, par exemple NH3, PH3 ou AsH3, avec un gaz porteur, et, à travers les ouvertures de sortie de gaz (25) de la chambre d'admission de gaz (9) centrale, un composé organométallique, par exemple TMGa, TMIn ou TMAl, **caractérisée en ce que** le flux global des gaz introduits dans la chambre de traitement à travers les ouvertures de sortie de gaz (25) est supérieur à 100 slm, de préférence supérieur à 250 slm et **en ce que** la pression totale dans la chambre de traitement est supérieure à 400 mbar, de préférence supérieure à 800 mbar.
